# EUROPEAN PATENT SPECIFICATION

(11) **EP 4 243 059 B1**
(45) Date of publication and mention of the grant of the patent: **25.12.2024**
(21) Application number: 22161617.0
(22) Date of filing: 11.03.2022
(51) Int. Cl.: H01L 21/67, H01L 21/677, H01L 21/683, H01L 21/687

(54) **ARRANGEMENT FOR ROTATABLE POSITIONING OF A SUBSTRATE**
ANORDNUNG ZUM DREHBAREN POSITIONIEREN EINES SUBSTRATS
AGENCEMENT DE POSITIONNEMENT ROTATIF D'UN SUBSTRAT

(43) Date of publication of application: 13.09.2023
(73) Proprietor: Scienta Omicron GmbH, 65232 Taunusstein (DE)
(72) Inventor: HEISS, Martin, 65232 Taunusstein (DE); WALTER, Lars, 65439 Flörsheim (DE)
(74) Representative: Zacco Sweden AB

(56) References cited:
- WO-A1-2015/037701
- US-A- 6 089 630
- US-A1- 2006 252 000
- US-A1- 2009 087 932

## Description

### Technical field

The present invention relates to an arrangement for rotatable positioning of a substrate. More specifically the present invention relates to an arrangement for rotatable of a flat substrate in a vacuum chamber, which arrangement enables cooling of the flat substrate.

### Technical background

Many investigations of the properties of the surfaces of substrates require both accurate temperature control of the substrate and the ability to manipulate its orientation with respect to an incoming probe beam while being performed in a vacuum chamber. Similar requirements for accurate temperature control of the substrate and the ability to manipulate its orientation exist when performing different processes on a surface such as, e.g., plasma etching and deposition, in a vacuum chamber. Existing manipulators for manipulation of the orientation of a substrate may be configured for linear motion in one or more of three Cartesian coordinates, and for polar and azimuthal rotations. It is desirable to provide an efficient cooling of the substrate while enabling the movements.

In the article "Azimuthal rotation of a continuously cooled UHV substrate holder for surface physics investigations", Rev. Sci. Instrum. 63 (9), September 1992, pp. 4227-4228, an arrangement for simultaneous manipulation and cooling of a substrate is described. The arrangement comprises a vertical shaft around which polar rotation is enabled and a horizontal shaft around which azimuthal rotation is enabled. A substrate holder is attached to the horizontal shaft. The horizontal axis is rotatable in relation to the vertical shaft by means of an angular gear. The horizontal axis is linked to a cold finger in the vertical shaft by means of a copper braid. The copper braid limits the cooling of the substrate holder and thus the substrate.

In some investigations of the properties of the surfaces of substrates and when performing different processes on a surface of a substrate, it is necessary to cool the substrate to a very low temperature. Particularly when depositing metal layers to certain semiconductor substrates, it has been shown that cooling of the substrate can improve the layer quality for some applications. With the arrangements of the prior art, cooling of a substrate to very low temperatures while freely adjusting the substrate orientation to the orientation of a process source in a vacuum is difficult or impossible to achieve. In particular, this is the case for larger substrate areas, such as semiconductor wafers or substrates exposed to heat load radiating from deposition sources.

The following document is mentioned as being a pertinent prior art illustration:
US 2009/087932 A1 discloses a substrate supporting apparatus.

The following documents are also mentioned:
US 6089630 A
WO 2015/037701 A1
US 2006/252000 A1

### Summary of the invention

An object of the present invention is to provide an arrangement for manipulating a substrate having two essentially parallel main surfaces, which arrangement enables azimuthal rotation at the end of an arm extending into a vacuum chamber, which is an alternative to the arrangements of the prior art.

Another object of the present invention is to provide an arrangement for manipulating a substrate having two essentially parallel main surfaces, which arrangement enables azimuthal rotation at the end of an arm extending into a vacuum chamber, and enables a more efficient cooling of the substrate than what is possible with the arrangements of the prior art.

The above objects are fulfilled with an arrangement according to the independent claim.

Further advantages are provided with the features of the dependent claims. According to an aspect of the invention, an arrangement is provided for manipulating, in a vacuum chamber, a flat substrate having two main surfaces.

The arrangement comprises an arm having a first end to be arranged outside the vacuum chamber, a second end to be arranged in the vacuum chamber and a length axis extending between the first end and the second end. The arm comprises at the second end a cooling surface for cooling of the flat substrate in contact with the cooling surface. The cooling surface has a centre axis extending essentially perpendicular to the cooling surface and non-parallel to the length axis, and the cooling surface is configured to be cooled by cooling of the first end of the arm outside the vacuum chamber. The arrangement further comprises a clamping device for fastening the substrate in contact with the cooling surface. The arrangement is characterised in that the clamping device comprises a first bearing device arranged around the centre axis and movable in the direction along the centre axis, and a substrate clamping device. The substrate clamping device comprises a second bearing device in engagement with the first bearing device such that the second bearing device is rotatable around the centre axis, and a substrate engagement device, fixed to the second bearing device, and configured for engagement with the periphery of the substrate on a side of the substrate facing away from the cooling surface. The arrangement further comprises an adjustable actuation device, which is configured to apply an adjustable actuation force on the first bearing device in the direction along the centre axis, such that the substrate is pressed towards the cooling surface. The first bearing device and the second bearing device are configured for transfer of the actuation force from the first bearing device to the second bearing device and the substrate engagement device.

With an arrangement according to above, manipulation of a flat substrate in relation to a cooling surface is enabled in combination with efficient cooling of the substrate. By separating the axial movement of the substrate from the rotation of the substrate, an advantageous arrangement is achieved which provides a high thermal conductivity between the cooling surface and an attached flat substrate, while simultaneously providing the possibility of rotating the substrate around the centre axis by any arbitrary angle.

The fact that the substrate is flat means that it has major surfaces and minor surfaces, wherein the major surfaces are essentially parallel and distinctly greater than the minor surfaces. The surfaces do not have to be planar but may comprise structures. The surface of the substrate facing away from the cooling surface may have larger structures than the surface facing the cooling surface.

The dimensions of the structures on the major surfaces are preferably smaller than the thickness of the flat substrate.

The substrate may be constituted of different materials in different layers. However, it is also possible that the substrate comprises a single layer, such as a semiconductor wafer.

By means of the arrangement, it is further possible to have a large cross-sectional area on the arm all the way from the first end to the cooling surface, which enables a high thermal conductivity and therefore enables an efficient cooling of the substrate.

The adjustable actuation device may be implemented in many different ways. An important feature of the adjustable actuation device is that it provides an adjustable actuation force. With a higher actuation force, the cooling efficiency may be improved, while a lower actuation force facilitates the rotation of the substrate in relation to the cooling surface.

The arm may comprise, at the second end of the arm, a protrusion part, which extends between the arm and the cooling surface, wherein the first bearing device and the second bearing device are arranged around the protrusion part. With such a protrusion part and with such an arrangement of the first bearing device and the second bearing device, the access to the cooling surface is improved and thus the access to a substrate clamped to the cooling surface. In other words, particles and radiation may reach the substrate from a larger solid angle compared to the case where no protrusion part exists as the first bearing device and the second bearing device then would have to be arranged on the same side of the cooling surface as the substrate.

The length axis of the arm may be arranged orthogonally to a process device, such as, e.g., a deposition source. In this case orthogonal arrangement of the arm means that the direction of deposition is orthogonal to the length axis of the arm. In this configuration, the substrate surface on the arm can be aligned to any arbitrary direction from normal incidence to glancing incidence. This is beneficial to control the deposition in substrates that carry microstructures on their front that have side surfaces which are not parallel to the main substrate front surface.

The cooling surface may have a smaller maximum extension than the maximum extension across the substrate between points of engagement between the substrate engagement device and the substrate. A substrate is clamped towards the cooling surface by the force from the substrate engagement device on the substrate. An equally large counterforce is applied on the substrate by the cooling surface. Due to the difference in extension, the torque of the force from the substrate engagement device will be larger than the torque of the force from the cooling surface in case the coefficient of friction between the cooling surface and the substrate is equal to the coefficient of friction between the substrate engagement device and the substrate. Thus, the rotation of the substrate is enabled while keeping the substrate in contact with the cooling surface.

The substrate engagement device may be configured for rotationally fixed engagement with the substrate. Such a configuration will enable rotation of the substrate even if the coefficient of friction between the cooling surface and the substrate is not less than or equal to the coefficient of friction between the substrate engagement device and the substrate.

The adjustable actuation device may be configured to apply the adjustable actuation force between the first bearing device and a surface of the arm opposite to the cooling surface. Such an arrangement facilitates an even application of the adjustable actuation force. Also, such an arrangement provides a large space for the adjustable actuation device.

The substrate engagement device and the second bearing device may be a single ring-formed part. By such an arrangement, the assembly of the clamping device is facilitated.

The outer surface of the substrate engagement device and the second bearing device may comprise indentations or protrusions for engagement with protrusions and indentations, respectively, on a wheel of a first actuator device for rotation of the substrate engagement device and the second bearing device in relation to the first bearing device. With such indentations or protrusions, a well-controlled rotation of the substrate is achieved.

The arm may be rotatable around its length axis. With such an arrangement, the substrate may be manipulated around two axes, while maintaining a high thermal conductivity between the first end of the arm and the cooling surface.

The rotation of the arm around the length axis may be performed manually. Alternatively, the arrangement may comprise a second actuator for rotation of the arm around its length axis.

The centre axis is may be perpendicular to the length axis. This provides a well-controlled manipulation of the substrate.

The arrangement may be configured such that the surface of a substrate, with a predetermined thickness, at the centre axis is at the essentially same position irrespective of the rotational position of the arm around the length axis. Said surface is facing away from the cooling surface. This is favourable for example when a source of deposition is to be maintained at a constant distance from a substrate.

A continuous part of the arm, from the first end to the cooling surface, may be made of copper, silver, molybdenum or platinum. The continuous part may comprise joints. It is important that any joints are designed such that they have a high thermal conductivity. The entire arm may constitute the continuous part.

In the following, preferred embodiments of the invention will be described with reference to the appended drawings.

### Brief description of the drawings

Figure 1 shows an arrangement for manipulating, in a vacuum chamber, a flat substrate.
Figure 2 shows in a cross-sectional view a clamping device of the arrangement of Figure 1, with a substrate attached in the clamping device.
Figure 3 shows in a cross-sectional view the clamping device of Figure 2 without a substrate attached.
Figures 4 and 5 illustrate in perspective views the clamping device of Figures 2 and 3. In Figure 4, a substrate is arranged in the clamping device.
Figure 6 is a plan view seen along a length axis or the arm in Figure 1.
Figure 7 is a perspective view of the clamping device.
Figure 8 is perspective view of a substrate.

### Detailed description of embodiments

In the following embodiments of the invention will be described with reference to the appended drawings. The same features are denoted by the same reference numerals in the different drawings. The drawings are not drawn to scale.

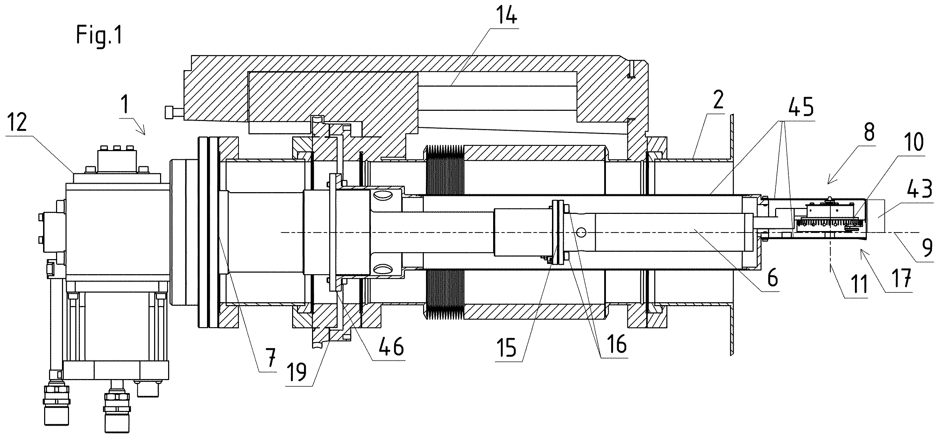

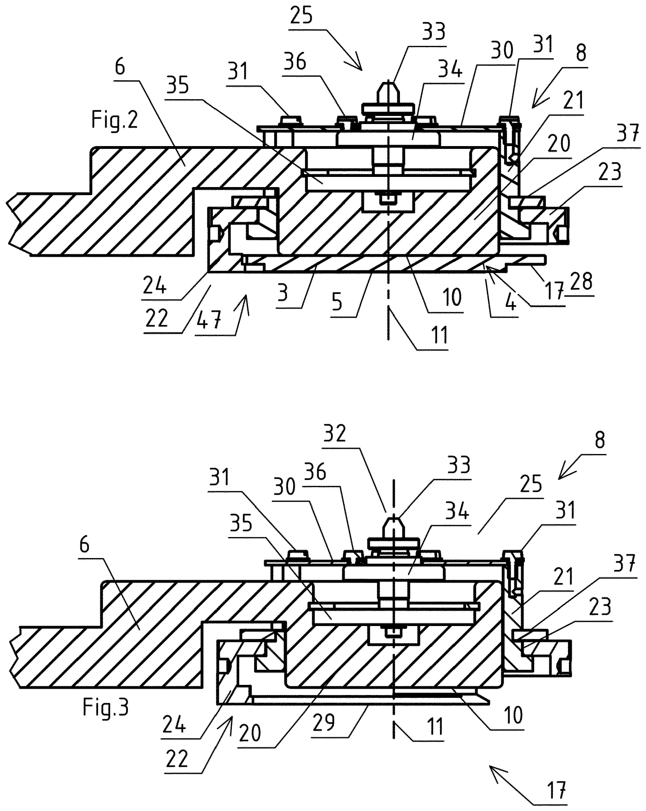

Figure 1 shows an arrangement 1 for manipulating, in a vacuum chamber 2, a flat substrate 3 (Figure 2) having two main surfaces 4, 5 (Figure 2), the arrangement 1 comprises an arm 6 having a first end 7 to be arranged outside the vacuum chamber 2, a second end 8 to be arranged in the vacuum chamber 2 and a length axis 9 extending between the first 7 end and the second end 8. The object of the arrangement shown in Figure 1 is to enable simultaneous manipulation and cooling of a flat substrate 3 (Figure 2) at the second end 8 of the arm 6. The fact that the substrate 3 to be manipulated and cooled is flat means that it has major surfaces and minor surfaces, wherein the major surfaces are essentially parallel and distinctly greater than the minor surfaces. The arm 6 comprises at the second end 8 a cooling surface 10 for cooling of the flat substrate 3 (Figure 2) in contact with the cooling surface 10, wherein the cooling surface 10 has a centre axis 11 extending essentially perpendicular to the cooling surface 3 and non-parallel to the length axis 9. The fact that the centre axis 11 extends essentially perpendicular to the cooling surface 10 is to be understood as that the centre axis 11 extends at an angle of 90 ± 5 degrees or even more preferably 90 ± 1 degrees from the cooling surface 10. Thus, it is possible that the centre axis 11 does not extend perfectly perpendicular to the cooling surface 10. The cooling surface 10 is preferably planar but may have a slight curvature and/or protrusions. In case the cooling surface is curved, it is preferably convex. The height difference between the lowest part of the cooling surface and the highest part of the cooling surface is preferably smaller than 1 percent of the maximum extension of the cooling surface. In case the cooling surface is curved and/or has protrusions, they are preferably arranged with symmetry to the centre axis 11.

The cooling surface 10 is configured to be cooled by cooling of the first end 7 of the arm 6 outside the vacuum chamber 2. In order to enable cooling of the first end 7 of the arm 6 outside the vacuum chamber 2 the arrangement comprises a cryocooling unit 12 at the first end 7. The cryocooling chamber 12 may be a known refrigerator such as a multi stage Gifford-MacMahon (GM) refrigerator, a pulse tube refrigerator or a heat exchanger cryostat that is externally supplied with coolant fluid. The cooling fluid may for example be liquid helium or liquid nitrogen, but other cooling fluids may be contemplated depending on the desired temperature to be achieved on the cooling surface 10.

It is preferential to enclose the arm by a heat shield 45. The heat shield 45 is preferably attached to an intermediate stage of a cooling assembly 46 in order to minimize the thermal radiation to the cooling arm 6 from the surrounding or from other process sources in the chamber 2. Suitable openings in the bottom or the side of the heat shield can ensure deposition or other processes to only occur on parts of the substrate arrangement 3 while ensuring no deposition or other process occurs to other parts of the mechanism.

To be able to achieve a low temperature on the cooling surface 10 it is necessary to have a high thermal conductivity in the arm 6 from the cooling surface 10 to the cooling chamber 12. To be able to achieve a high thermal conductivity in the arm 6 a continuous part of the arm, from the first end to the cooling surface, is made of a material having a low specific thermal resistivity at low temperatures. The continuous part may be made of copper, silver, molybdenum and/or platinum. In case copper is used, it is advantageous to use oxygen free high conductivity copper. The continuous part may comprise joints such as the joint 15, which is secured with bolts 16. It is important that the joints are designed such that every joint has a high thermal conductivity. In Figure 1, the entire arm may constitute the continuous part. However, it is also possible that some parts of the arm are not made of the material having a low specific thermal resistivity such as, e.g., the bolts 16. Furthermore, it is of course possible to have different parts of the continuous part of different materials. One part may be of, e.g., copper, while an adjoining part may be made of another material such as, e.g., silver.

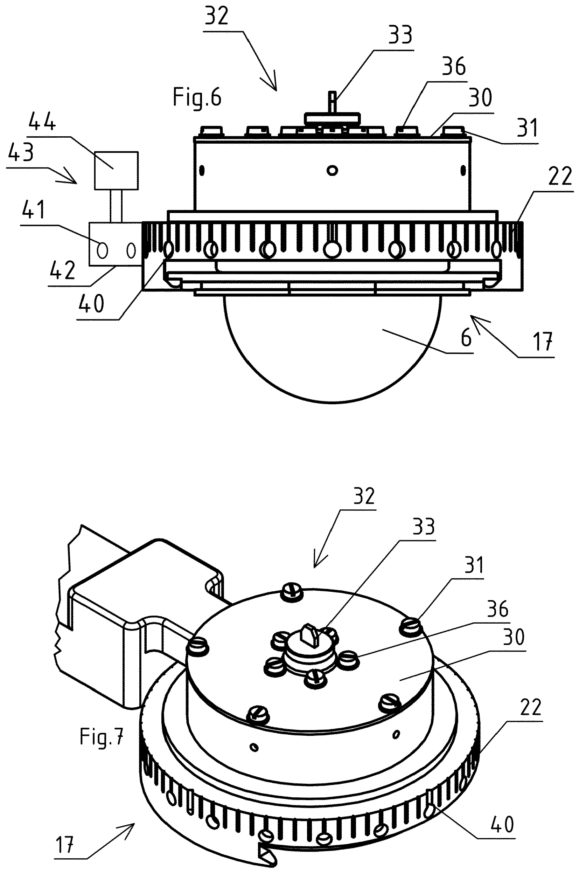

The arrangement comprises, at the second end 8, a clamping device 17 for fastening the substrate 3 (Figure 2) in contact with the cooling surface 10. The arrangement 1 comprises a first actuator device 43 for rotation of the substrate 3 around the centre axis 11. The clamping device 17 and the first actuator device 43 will be described in more detail with reference to Figure 6 below. The clamping device is configured to enable exchange of the substrate 3.

The arm is rotatable around the length axis 9 by means of a second actuator 19. Preferably, the arrangement is configured such that the surface of the substrate 3, facing away from the cooling surface 10, at the centre axis 11 is at the essentially same position irrespective of the rotational position of the arm 6 around the length axis 9. This is advantageous when a substrate 3 is positioned in the clamping device and is to be subject to some kind of process, such as, e.g., deposition, as the substrate then may rotated around the length axis 9 without changing the distance to the deposition source. The primary desirable technical effect is to maintain the position of the surface of the substrate 3 (Figure 2) at the centre axis 11 and not the cooling surface 10 at the centre axis 11. This requires that a substrate 3 with known predetermined thickness is used. However, smaller movements of the surface of the substrate 3 at the centre axis may be acceptable in many applications. In such cases, the thickness of the substrate must not be predetermined.

The arrangement 1 may be equipped with additional actuators for linear actuation of the entire arm along one or more linear axis 14. This can allow more precise alignment of the position of a substrate arrangement 3 subject to some process in the chamber 2.

Figure 2 shows in a cross-sectional view the clamping device 17 described above with a substrate 3 attached in the clamping device 17. Figure 3 shows in a cross-sectional view the clamping device 17 without a substrate attached in the clamping device 17. Only the second end 8 of the arm 6 is shown in Figure 2. The arm 6 comprises, at the second end 8, a protrusion part 20, which extends between the arm 6 and the cooling surface.

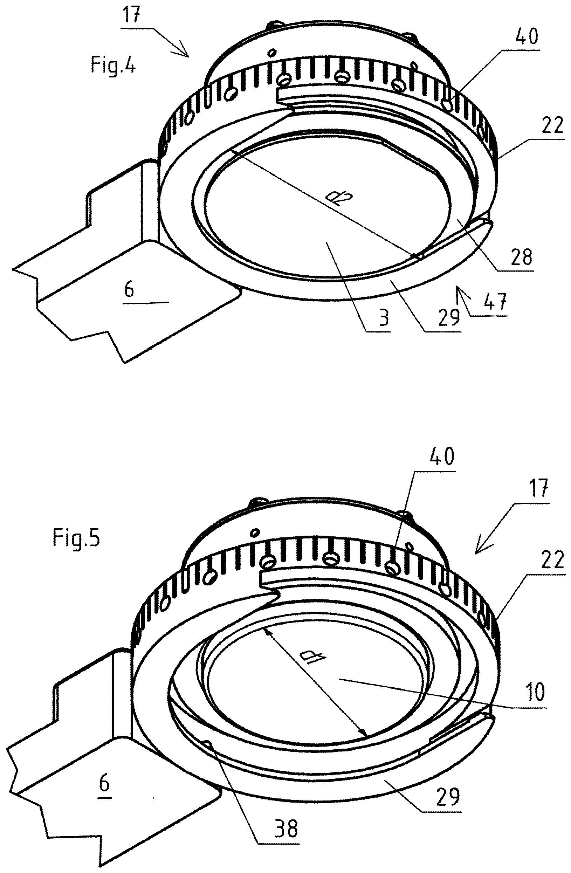

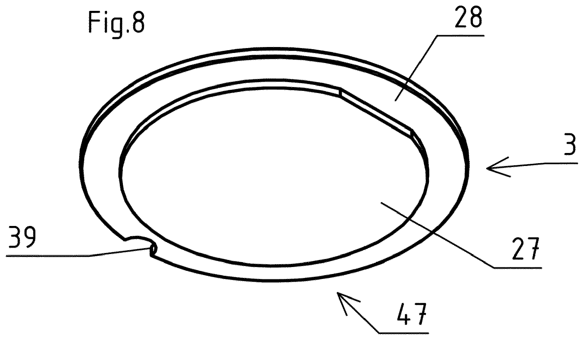

Figures 4 and 5 illustrate in a perspective view the clamping device 17 of Figures 2 and 3. In Figure 4, a substrate 3 is arranged in the clamping device 17. Figure 6 is a plan view seen along the length axis 9 in the direction from the second end 8 towards the first end 7. Figure 7 is a perspective view of the clamping device. Figure 8 is plan view of the substrate 3.

The clamping device 17 comprises a first bearing device 21 arranged around the centre axis 11 and movable in the direction along the centre axis 11. The first bearing device 21 is arranged around the protrusion part 20. The clamping device 17 also comprises a substrate clamping device 22 comprising a second bearing device 23 arranged around the protrusion part 20 and in engagement with the first bearing device 21 such that the second bearing device 23 is rotatable around the centre axis 11 by an arbitrary angle. The substrate clamping device 22 also comprises a substrate engagement device 24, fixed to the second bearing device 23, and configured for engagement with the periphery of the substrate on a side of the substrate 3 facing away from the cooling surface 10. In the illustrated embodiment the substrate engagement device 24 and the second bearing device 23 is a single ring formed part.

The clamping device also comprises an adjustable actuation device 25, which is configured to apply an adjustable actuation force on the first bearing device 21 in the direction along the centre axis 11, such that the substrate 3 is pressed towards the cooling surface 10. The first bearing device 21 and the second bearing device 23 are configured for transfer of the actuation force from the first bearing device 21 to the second bearing device 23 and the substrate engagement device 24.

In Figure 2 the substrate 3 has a stepped cross-sectional form. A first side 4 of the substrate 3 is arranged against the cooling surface 10 while a second side 5 of the substrate 3 is arranged facing away from the cooling surface 10. The substrate 3 may consist of several materials bonded together e.g. by soldering, preferably with a low melting point metal such as gallium, indium or an alloy of gallium or indium. In some usage of the assembly, the front surface of the substrate 3, i.e., the surface of the substrate facing away from the cooling surface 10, may be composed of a semiconductor wafer while the holder 28 of the substrate arrangement may be composed of a material with high thermal conductivity at low temperature such as oxygen free high conductivity copper, silver, molybdenum, or platinum. The holder 28 has a larger extension than the semiconductor wafer. This results in that the periphery of the substrate 3 is thinner than the rest of the substrate 3. The step in the thickness is at the second side 5 of the substrate 3.The periphery of the substrate 47, in this embodiment the periphery of the holder 28, is in contact with the substrate engagement device 24. The step in the cross-sectional shape of the substrate 3 results in that the engagement device not protrudes below the second side 5 of the substrate. This means that the access to the second side 5 of the substrate is improved. As can be seen in Fig 3 the substrate engagement device comprises a shelf 29 on which the periphery 47 of the substrate 3 (Figure 2) may be supported. It is of course possible to have a substrate 3 comprising only a single layer, which may or may not comprise a step in thickness at the periphery. The substrate 3 may for example be a semiconductor wafer.

The actuation device 25 will now be described in larger detail. In the embodiment illustrated in Figure 2 and Figure 3 the actuation device 25 comprises a disc spring 30, i.e., a circular disc. The periphery of the disc spring 30 is connected to the first bearing device 21 by means of first screws 31. The central part of the disc spring is attached to an actuator 32, which in the illustrated embodiment comprises of an adjustment screw 33 in threaded engagement with a disc 34 and in rotational engagement with a bottom plate 35. The disc 34 is connected to the disc spring 30 by means of second screws 36. When rotating the adjustment screw the adjustment screw will force the disc 34 up or down depending on the direction of rotation. When the disc is moved upwards, the disc spring 30 will transfer the movement to the first bearing device 21 in the direction along the centre axis and also to the second bearing device 23 and the substrate engagement device 24. In Figure 2, the substrate engagement device 24 is in contact with the substrate 3, which is in contact with the cooling surface. The substrate 3 is pressed towards the cooling surface by the substrate engagement device 24. When the disc 34 is moved upwards in Figure 2 this will result in an increased force between the bottom plate 35 and the disc 34 and thus in an increased force from the disc spring 30 on the first bearing device 21, on the second bearing device 23 and the substrate engagement device 24. Thus, by rotation of the adjustment screw an adjustable actuation force is applied on the first bearing device 21, the second bearing device 23 and the substrate engagement device 24. Also shown in Figure 2 and in Figure 3 is a locking ring 37, which prevents movement of the second bearing device 23 in relation to the first bearing device 21.

It is possible to use a different actuation device 25 than the one illustrated in Figure 2 and Figure 3. It would be possible to replace the adjustment screw with a piezoelectric actuator. It is of course not necessary to apply the force between the arm 6 and the substrate engagement device 24 as illustrated in Figure 2 and Figure 3.

It would be possible to omit the protrusion part 20. However, this would result in that the first bearing device 21 and the second bearing device 23 would have to protrude below the cooling surface 10. This would make the second surface 5 of the substrate 3 less accessible.

In the embodiment illustrated in Figure 2 the cooling surface 10 has a smaller maximum extension than the maximum extension across the substrate 3 between points of engagement between the substrate engagement device 24 and the substrate. This facilitates the rotation of the substrate 3 in relation to the cooling surface 10. Assuming that the coefficient of friction between the substrate engagement device 24 and the substrate 3 is the same as the coefficient of friction between the cooling surface 10 and the substrate 3, the larger diameter at the periphery will result in a larger torque from the substrate engagement device 24. However, in case the coefficient of friction between the substrate engagement device 24 and the substrate 3 is lower than the coefficient of friction between the cooling surface 10 and the substrate 3 it may be advantageous to have the substrate engagement device configured for rotationally fixed engagement with the substrate. As can be seen in Figure 5 a protrusion 38 is formed in the substrate engagement device 24. The protrusion is to engage with a corresponding indentation 39 in the substrate 3 as can be seen in Figure 8.

As can be seen in Figures 4-7 the outer surface of the substrate engagement device 24 and the second bearing device 23 comprises indentations 40 for engagement with protrusions 41, on a wheel 42 (Figure 6) of a first electric actuator device 43 for rotation of the substrate engagement device 24 and the second bearing device 23 in relation to the first bearing device. It is of course possible to have indentations on the wheel 42 and protrusions on the substrate engagement device 24 and the second bearing device 23. The first actuator device 43 and the adjustment screw 33 may either be configured to be operated manually from outside the vacuum chamber or automatically with an electric actuator motor 44 as shown for the wheel 42 in Figure 6.

The above described embodiments may be amended in many ways without departing from the scope of the invention, which is limited only by the appended claims.

## Claims

1. Arrangement (1) for manipulating, in a vacuum chamber (2), a flat substrate (3) having two main surfaces (4, 5), the arrangement (1) comprising:
- an arm (6) having a first end (7) to be arranged outside the vacuum chamber (2), a second end (8) to be arranged in the vacuum chamber (2) and a length axis (9) extending between the first end (7) and the second end (8), wherein the arm (6) at the second end (8) comprises:
- a cooling surface (10) for cooling of the flat substrate (3) in contact with the cooling surface (10), wherein the cooling surface (10) has a centre axis (11) extending essentially perpendicular to the cooling surface (10) and non-parallel to the length axis (9), and wherein the cooling surface (10) is configured to be cooled by cooling of the first end (7) of the arm (6) outside the vacuum chamber (2), and
- a clamping device (17) for fastening the substrate (3) in contact with the cooling surface (10), wherein the clamping device (17) comprises:
- a first bearing device (21) arranged around the centre axis (11) and movable in the direction along the centre axis (11),
- a substrate clamping device (22) comprising
a second bearing device (23) in engagement with the first bearing device (21) such that the second bearing device (23) is rotatable around the centre axis (11), and
a substrate engagement device (24), fixed to the second bearing device (23), and configured for engagement with the periphery (47) of the substrate on a side of the substrate facing away from the cooling surface (10); and
- an adjustable actuation device (25), which is configured to apply an adjustable actuation force on the first bearing device (21) in the direction along the centre axis (11), such that the substrate (3) is pressed towards the cooling surface (10), wherein the first bearing device (21) and the second bearing device (23) are configured for transfer of the actuation force from the first bearing device (21) to the second bearing device (23) and the substrate engagement device (24).

2. The arrangement (1) according to claim 1, wherein the arm (6) comprises, at the second end (8) of the arm (6), a protrusion part (20), which extends between the arm (6) and the cooling surface (10), wherein the first bearing device (21) and the second bearing device (23) are arranged around the protrusion part (20).

3. The arrangement (1) according to claim 1 or 2, wherein the cooling surface (10) has a smaller maximum extension (d1) than the maximum extension (d2) across the substrate (3) between points of engagement between the substrate engagement device (24) and the substrate (3).

4. The arrangement (1) according to claim 3, wherein the substrate engagement device (24) is configured for rotationally fixed engagement with the substrate (3).

5. The arrangement (1) according to anyone of the preceding claims, wherein the adjustable actuation device (25) is configured to apply the adjustable actuation force between the first bearing device (21) and a surface of the arm opposite to the cooling surface (10).

6. The arrangement (1) according to anyone of the preceding claims, wherein the substrate engagement device (24) and the second bearing device (23) is a single ring formed part.

7. The arrangement (1) according to claim 6, wherein the outer surface of the substrate engagement device (24) and the second bearing device (23) comprises indentations (40) or protrusions for engagement with protrusions (41) and indentations, respectively, on a wheel (42) of a first actuator device (43) for rotation of the substrate engagement device (24) and the second bearing device (23) in relation to the first bearing device (21).

8. The arrangement (1) according to anyone of the preceding claims, wherein the arm (6) is rotatable around its length axis (9).

9. The arrangement (1) according to claim 8, comprising a second actuator (19) for rotation of the arm (6) around its length axis (9).

10. The arrangement (1) according to claim 8 or 9, wherein the centre axis (11) is perpendicular to the length axis (9).

11. The arrangement (1) according to anyone of claims 8-10, which is configured such that the surface (10) of a substrate (3), with a predetermined thickness, at the centre axis (11) is at the essentially same position irrespective of the rotational position of the arm (6) around the length axis (9).

12. The arrangement (1) according to anyone of the preceding claims, wherein a continuous part of the arm (6), from the first end to the cooling surface (10), is made of copper, silver, molybdenum or platinum.

## Patentansprüche

1. Anordnung (1) zum Handhaben, in einer Vakuumkammer (2), eines flachen Substrats (3), das zwei Hauptflächen (4, 5) aufweist, wobei die Anordnung (1) Folgendes umfasst:
- einen Arm (6), der ein erstes Ende (7), das außerhalb der Vakuumkammer (2) anzuordnen ist, ein zweites Ende (8), das in der Vakuumkammer (2) anzuordnen ist, und eine Längsachse (9), die sich zwischen dem ersten Ende (7) und dem zweiten Ende (8) erstreckt, aufweist, wobei der Arm (6) an dem zweiten Ende (8) Folgendes umfasst:
- eine Kühlfläche (10) zum Kühlen des flachen Substrats (3) in Kontakt mit der Kühlfläche (10), wobei die Kühlfläche (10) eine Mittelachse (11) aufweist, die sich im Wesentlichen senkrecht zu der Kühlfläche (10) und nicht parallel zu der Längsachse (9) erstreckt, und wobei die Kühlfläche (10) dazu konfiguriert ist, durch Kühlen des ersten Endes (7) des Arms (6) außerhalb der Vakuumkammer (2) gekühlt zu werden, und
- eine Klemmeinrichtung (17) zum Befestigen des Substrats (3) in Kontakt mit der Kühlfläche (10), wobei die Klemmeinrichtung (17) Folgendes umfasst:
- eine erste Lagereinrichtung (21), die um die Mittelachse (11) angeordnet und in der Richtung entlang der Mittelachse (11) bewegbar ist,
- eine Substrat-Klemmeinrichtung (22), umfassend
eine zweite Lagereinrichtung (23) in Eingriff mit der ersten Lagereinrichtung (21), sodass die zweite Lagereinrichtung (23) um die Mittelachse (11) drehbar ist, und
eine Substrat-Eingriffseinrichtung (24), die an der zweiten Lagereinrichtung (23) angebracht und zum Eingriff mit der Peripherie (47) des Substrats auf einer Seite des Substrats, die von der Kühlfläche (10) abgewandt ist, konfiguriert ist; und
- eine einstellbare Betätigungseinrichtung (25), die dazu konfiguriert ist, eine einstellbare Betätigungskraft auf die erste Lagereinrichtung (21) in der Richtung entlang der Mittelachse (11) anzuwenden, sodass das Substrat (3) gegen die Kühlfläche (10) gedrückt wird, wobei die erste Lagereinrichtung (21) und die zweite Lagereinrichtung (23) für die Übertragung der Betätigungskraft von der ersten Lagereinrichtung (21) zu der zweiten Lagereinrichtung (23) und der Substrat-Eingriffseinrichtung (24) konfiguriert sind.

2. Anordnung (1) nach Anspruch 1, wobei der Arm (6), an dem zweiten Ende (8) des Arms (6), ein Vorsprungsteil (20), das sich zwischen dem Arm (6) und der Kühlfläche (10) erstreckt, umfasst, wobei die erste Lagereinrichtung (21) und die zweite Lagereinrichtung (23) um das Vorsprungsteil (20) angeordnet sind.

3. Anordnung (1) nach Anspruch 1 oder 2, wobei die Kühlfläche (10) eine kleinere maximale Erstreckung (d1) als die maximale Erstreckung (d2) über das Substrat (3) zwischen Eingriffspunkten zwischen der Substrat-Eingriffseinrichtung (24) und dem Substrat (3) aufweist.

4. Anordnung (1) nach Anspruch 3, wobei die Substrat-Eingriffseinrichtung (24) zum drehfesten Eingriff mit dem Substrat (3) konfiguriert ist.

5. Anordnung (1) nach einem der vorhergehenden Ansprüche, wobei die einstellbare Betätigungseinrichtung (25) dazu konfiguriert ist, die einstellbare Betätigungskraft zwischen der ersten Lagereinrichtung (21) und einer Fläche des Arms gegenüber der Kühlfläche (10) anzuwenden.

6. Anordnung (1) nach einem der vorhergehenden Ansprüche, wobei es sich bei der Substrat-Eingriffseinrichtung (24) und der zweiten Lagereinrichtung (23) um ein einzelnes ringförmiges Teil handelt.

7. Anordnung (1) nach Anspruch 6, wobei die Außenfläche der Substrat-Eingriffseinrichtung (24) und der zweiten Lagereinrichtung (23) Vertiefungen (40) oder Vorsprünge zum Eingriff mit Vorsprüngen (41) bzw. Vertiefungen auf einem Rad (42) einer ersten Aktoreinrichtung (43) zur Drehung der Substrat-Eingriffseinrichtung (24) und der zweiten Lagereinrichtung (23) in Bezug auf die erste Lagereinrichtung (21) umfasst.

8. Anordnung (1) nach einem der vorhergehenden Ansprüche, wobei der Arm (6) um dessen Längsachse (9) drehbar ist.

9. Anordnung (1) nach Anspruch 8, umfassend einen zweiten Aktor (19) zur Drehung des Arms (6) um dessen Längsachse (9).

10. Anordnung (1) nach Anspruch 8 oder 9, wobei die Mittelachse (11) senkrecht zu der Längsachse (9) ist.

11. Anordnung (1) nach einem der Ansprüche 8-10, die so konfiguriert ist, dass sich die Fläche (10) eines Substrats (3), mit einer vorbestimmten Dicke, an der Mittelachse (11) unabhängig von der Drehposition des Arms (6) um die Längsachse (9) in der im Wesentlichen gleichen Position befindet.

12. Anordnung (1) nach einem der vorhergehenden Ansprüche, wobei ein durchgehender Teil des Arms (6), von dem ersten Ende zu der Kühlfläche (10), aus Kupfer, Silber, Molybdän oder Platin hergestellt ist.

## Revendications

1. Agencement (1) de manipulation, dans une chambre à vide (2), d'un substrat plat (3) ayant deux surfaces principales (4, 5), l'agencement (1) comprenant :
- un bras (6) ayant une première extrémité (7) à agencer à l'extérieur de la chambre à vide (2), une seconde extrémité (8) à agencer dans la chambre à vide (2) et un axe longitudinal (9) s'étendant entre la première extrémité (7) et la seconde extrémité (8), le bras (6) au niveau de la seconde extrémité (8) comprenant :
- une surface de refroidissement (10) pour refroidir le substrat plat (3) en contact avec la surface de refroidissement (10), la surface de refroidissement (10) ayant un axe central (11) s'étendant essentiellement perpendiculairement à la surface de refroidissement (10) et non parallèle à l'axe longitudinal (9), et la surface de refroidissement (10) étant configurée pour être refroidie par refroidissement de la première extrémité (7) du bras (6) à l'extérieur de la chambre à vide (2), et
- un dispositif de serrage (17) pour fixer le substrat (3) en contact avec la surface de refroidissement (10), dans lequel le dispositif de serrage (17) comprend :
- un premier dispositif de palier (21) disposé autour de l'axe central (11) et mobile dans la direction le long de l'axe central (11),
- un dispositif de serrage de substrat (22) comprenant
un second dispositif de palier (23) en prise avec le premier dispositif de palier (21) de sorte que le second dispositif de palier (23) puisse tourner autour de l'axe central (11), et
un dispositif de mise en prise de substrat (24), fixé au second dispositif de palier (23), et configuré pour venir en prise avec la périphérie (47) du substrat sur un côté du substrat tourné à l'opposé de la surface de refroidissement (10) ; et
- un dispositif d'actionnement réglable (25), qui est configuré pour appliquer une force d'actionnement réglable sur le premier dispositif de palier (21) dans la direction le long de l'axe central (11), de sorte que le substrat (3) soit pressé vers la surface de refroidissement (10), le premier dispositif de palier (21) et le second dispositif de palier (23) étant configurés pour transférer la force d'actionnement du premier dispositif de palier (21) au second dispositif de palier (23) et au dispositif de mise en prise de substrat (24) .

2. Agencement (1) selon la revendication 1, dans lequel le bras (6) comprend, au niveau de la seconde extrémité (8) du bras (6), une partie en saillie (20), qui s'étend entre le bras (6) et la surface de refroidissement (10), le premier dispositif de palier (21) et le second dispositif de palier (23) étant disposés autour de la partie en saillie (20).

3. Agencement (1) selon la revendication 1 ou 2, dans lequel la surface de refroidissement (10) présente une extension maximale (d1) plus petite que l'extension maximale (d2) à travers le substrat (3) entre des points de mise en prise entre le dispositif de mise en prise de substrat (24) et le substrat (3).

4. Agencement (1) selon la revendication 3, dans lequel le dispositif de mise en prise de substrat (24) est configuré pour une mise en prise fixe en rotation avec le substrat (3).

5. Agencement (1) selon l'une quelconque des revendications précédentes, dans lequel le dispositif d'actionnement réglable (25) est configuré pour appliquer la force d'actionnement réglable entre le premier dispositif de palier (21) et une surface du bras opposée à la surface de refroidissement (10).

6. Agencement (1) selon l'une quelconque des revendications précédentes, dans lequel le dispositif de mise en prise de substrat (24) et le second dispositif de palier (23) constituent une pièce unique formée d'anneau.

7. Agencement (1) selon la revendication 6, dans lequel la surface extérieure du dispositif de mise en prise de substrat (24) et du second dispositif de palier (23) comprend des indentations (40) ou des saillies pour une mise en prise avec des saillies (41) et des indentations, respectivement, sur une roue (42) d'un premier dispositif d'actionnement (43) pour la rotation du dispositif de mise en prise de substrat (24) et du second dispositif de palier (23) par rapport au premier dispositif de palier (21).

8. Agencement (1) selon l'une quelconque des revendications précédentes, dans lequel le bras (6) peut tourner autour de son axe longitudinal (9).

9. Agencement (1) selon la revendication 8, comprenant un second actionneur (19) pour la rotation du bras (6) autour de son axe longitudinal (9).

10. Agencement (1) selon la revendication 8 ou 9, dans lequel l'axe central (11) est perpendiculaire à l'axe longitudinal (9) .

11. Agencement (1) selon l'une quelconque des revendications 8 à 10, qui est configuré de telle sorte que la surface (10) d'un substrat (3), d'une épaisseur prédéterminée, au niveau de l'axe central (11) se trouve à la même position essentiellement quelle que soit la position de rotation du bras (6) autour de l'axe longitudinal (9).

12. Agencement (1) selon l'une quelconque des revendications précédentes, dans lequel une partie continue du bras (6), depuis la première extrémité à la surface de refroidissement (10), est constituée de cuivre, d'argent, de molybdène ou de platine.
